# EUROPÄISCHE PATENTSCHRIFT

(11) **EP 0 294 590 B1**
(45) Veröffentlichungstag und Bekanntmachung des Hinweises auf die Patenterteilung: **04.08.1993**
(21) Anmeldenummer: 88107213.6
(22) Anmeldetag: 05.05.1988
(51) Int. Cl.: G01R 15/02, G01R 19/20

(54) **Stromsensor nach dem Kompensationsprinzip**
Compensation principle current sensor
Capteur de courant selon le principe de la compensation

(30) Priorität: 05.06.1987 DE 3718857
(43) Veröffentlichungstag der Anmeldung: 14.12.1988
(73) Patentinhaber: Vacuumschmelze GmbH, 63450 Hanau (DE)
(72) Erfinder: Nilius, Hans-Joachim, D-6453 Seligenstadt (DE); Hinz, Gerhard, Dipl.-Phys., D-8755 Alzenau (DE)

(56) Entgegenhaltungen:
- EP-A- 0 132 745
- DE-A- 3 241 018
- US-A- 4 309 655
- US-A- 4 536 706
- PROCEEDINGS OF THE IEE 4th CONFERENCE ON AC AND DC POWER TRANSMISSION, London, 23.-26. September 1985, Seiten 229-234; J. LISSER et al.: "Zero-flux current transformer for wide-band precision measurement in AC and DC HV systems"

## Beschreibung

Die Erfindung bezieht sich auf einen Stromsensor nach dem Kompensationsprinzip gemäß dem Oberbegriff des Patentanspruchs 1.

Zur Messung von Gleich- und Wechselströmen wird häufig das Kompensationsprinzip verwendet, bei dem das in einem Magnetkern vom Meßstrom erzeugte Magnetfeld durch einen Kompensationsstrom in einer Sekundärwicklung kompensiert wird. Zur Steuerung des Kompensationsstromes ist im Magnetkreis ein Detektor vorgesehen, der die Abweichungen vom Nullfeld erfaßt. Der Sekundärstrom ist damit ein genaues Abbild des zu messenden Primärstroms.

In der ETZ, Bd. 100 (1979), Heft 24 ist auf Seite 1390 ein Prinzipschaltbild eines solchen Stromsensors dargestellt und näher beschrieben. Ferner ist es bekannt, das vom Meßstrom erzeugte Magnetfeld mit Hilfe einer Hallsonde als Detektor zu erfassen, welcher in einem Luftspalt eines Magnetkerns aus hochpermeablem Material angeordnet ist. Es hat sich aber gezeigt, daß sich bei hohen Anforderungen an die Nullpunkt-Konstanz durch die Trift der Hallsonde und der zur Auswertung erforderlichen Operationsverstärker Probleme ergeben.

Die Erkennung des kompensierten Zustandes ist auch auf magnetische Weise, z. B. durch periodisches Ummagnetisieren des Kerns und Auswerten der geradzahligen Oberwellen nach Betrag und Phase oder nach dem FörstersondenPrinzip möglich. Letzteres ist dem Aufsatz "Magnetfeldmessung mit Förstersonden und Hallgeneratoren" in der Zeitschrift ELEKTRONIK 1968, Heft 8, Seiten 247 ff. zu entnehmen.

Aus der europäischen Patentanmeldung 132 745 ist eine Einrichtung zum Messen von Gleichströmen bekannt, bei denen weichmagnetische streifenförmige Elemente periodisch vormagnetisiert werden und je eine Indikatorwicklung tragen, die über eine Verstärkerschaltung eine Kompensationswicklung steuert. Diese streifenförmigen Elemente sind in der Nähe von Querschnittsverminderungen des Magnetkerns (sogenannte Isthmen) angeordnet, so daß von den Indikatorwicklungen nur ein Teil des Flusses im Magnetkern umschlossen wird und sich deren Leistungsbedarf dadurch erheblich vermindert.

Nachteilig bei den bekannten Stromsensoren mit magnetischen Detektoren ist, daß die Ausgangsspannung mit steigendem Fehlabgleich zunächst zunimmt, bei größeren Fehlern, wie sie durch vorübergehende Störungen auftreten können, wieder abnimmt, und schon bei relativ niedrigen Werten unterhalb des Nennstromes zu Null werden. Dadurch kann der Kompensationsstrom durch Offsetspannungen in der Elektronik in falscher Richtung bis zum Maximalwert ansteigen; die Schaltung verliert sodann die Richtungserkennung.

Ein weiterer Nachteil entsteht dadurch, daß für sehr kleine Felder die Sensorkennlinie abflacht, weil praktisch der gesamte Fluß durch die Schenkel des Magnetkerns geht und nicht durch den Sensor. Für das Kompensationsprinzip ist aber gerade eine hohe Steilheit im Nulldurchgang wesentlich, um eine gute Genauigkeit zu erhalten.

Der Erfindung liegt die Aufgabe zugrunde, einen Stromsensor nach dem Oberbegriff des Patentanspruchs 1 derart zu gestalten, daß die beschriebenen Nachteile beseitigt sind. Gelöst wird diese Aufgabe durch die im Patentanspruch 1 gekennzeichneten Maßnahmen. Weitere Vorteile der Erfindung ergeben sich aus der nachfolgenden Beschreibung und den Merkmalen aus den Unteransprüchen.

Anhand der Zeichnung, in der mehrere Ausführungsbeispiele schematisch dargestellt sind, wird die Erfindung näher erläutert; es zeigen:
- Fig. 1: einen Stromsensor mit einem Magnetkern mit Luftspalt und zwei Indikatoren,
- Fig. 2: einen Teil einer an sich bekannten Schaltungsanordnung zur Auswertung der Signale,
- Fig. 3: einen Stromsensor mit einem weichmagnetischen Kern und im Luftspalt angeordneten Indikatorelement und
- Fig. 4: eine graphische Darstellung der Abhängigkeit des Ausgangsstromes Ia vom zu messenden Strom Im.

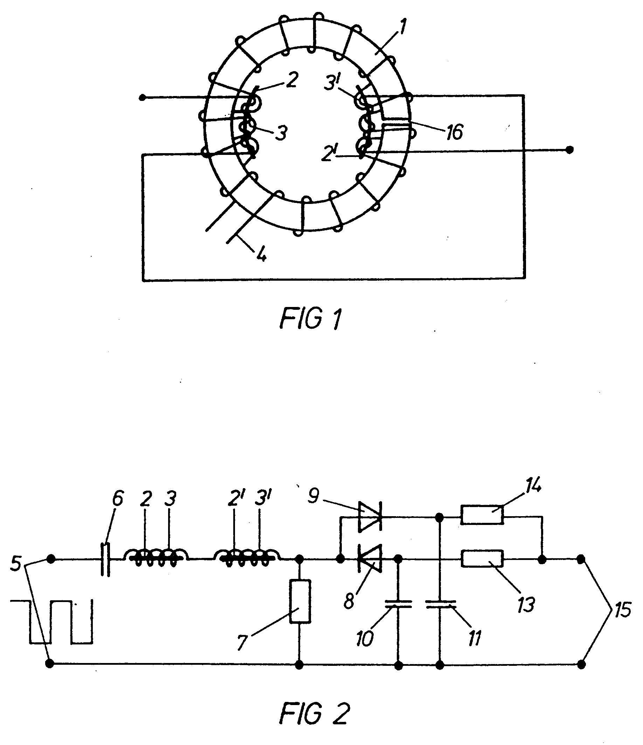

Der erfindungsgemäße Sensor gemäß Fig. 1 besteht aus einem Magnetkern 1 aus weichmagnetischem Material, durch den in an sich bekannter Weise die den zu messenden Strom führende Leitung als Primärwicklung hindurchgeführt wird. Am inneren Umfang des Magnetkerns 1 sind diametral gegenüberliegend zwei kurze streifenförmige Elemente 2 und 2' aus amorphem weichmagnetischem Material angeordnet.

Die streifenförmigen Elemente sind mit je einer Indikatorwicklung 3 bzw 3' versehen, die um die Elemente 2 und 2' gewickelt sind, wobei die Wicklungen beider Elemente 2 und 2' gleichsinnig in Reihe geschaltet sind. Die am inneren Umfang des Magnetkerns 1 angebrachten, mit den Indikatorwicklungen 3 und 3' versehenen streifenförmigen Elemente 2 und 2' sind von einer Sekundärwicklung 4 umschlossen, die sich über den gesamten Umfang des Magnetkerns 1 erstreckt.

Der Magnetkern 1 besitzt neben dem streifenförmigen Element 2' einen Luftspalt 16, während der zweite elektrisch in Reihe geschaltete Streifen 2 gegenüber im ungeschlitzten Teil des Magnetkerns 1 liegt. Bei kleinen Strömen ist das streifenförmige Element 2' mit hoher Empfindlichkeit wirksam, während bei großen Strömen das zweite streifenförmige Element 2 eine Richtungsinformation mit kleinerer Amplitude liefert.

Das Element 2 kann auch weggelassen werden, wenn das Element 2' länger ausgeführt ist, so daß bei hohen Strömen, wenn der Mittelteil bereits gesättigt ist, die Streifenenden noch ummagnetisiert werden können, um die Richtungsinformation zu liefern.

Fig. 2 zeigt die Anordnung der Indikatorwicklungen 3 und 3' in einer entsprechenden Auswahlschaltung. An die Eingangsklemmen 5 wird - wie angedeutet - eine Rechteckspannung angelegt. über einen Kondensator 6 und über einen Widerstand 7 sowie den beiden Indikatorwicklungen 3 und 3' fließen Impulsströme, die an dem Widerstand 7 entsprechende Spannungsabfälle hervorrufen, die mit Hilfe von Dioden 8 und 9 sowie Kondensatoren 10 und 11 über Widerstände 13 und 14 ausgekoppelt, gleichgerichtet und miteinander verglichen werden, so daß an den Ausgangsklemmen 15 ein der Abweichung vom Nullfluß proportionales Signal abgenommen werden kann, welches über eine entsprechende - nicht dargestellte - Auswerteschaltung zur Steuerung des Kompensationsstromes dient.

Der Kompensationsstrom sorgt in an sich bekannter Weise dafür, daß der magnetische Fluß im Kern 1 verschwindet. In diesem Falle sind die Stromspitzen symmetrisch, so daß der Mittelwert der an den Widerständen 13 und 14 abfallenden Spannungen gleich Null wird. Tritt jedoch eine Vormagnetisierung der streifenförmigen Elemente 2 infolge eines magnetischen Flusses im Magnetkern 1 auf, so werden die durch die Rechteckspannung hervorgerufenen Spannungsabfälle am Widerstand 7 ungleich, so daß an den Ausgangsklemmen 15 eine entsprechende Ausgangsspannung abgenommen werden kann.

Da die Länge der streifenförmigen Elemente 2 und 2' relativ klein gehalten werden kann, ist es möglich, die Feldstärke der Impulsmagnetisierung so hoch zu wählen, daß eine dauernde Sättigung der Streifen durch den Meß- oder Kompensationsstrom vermieden wird.

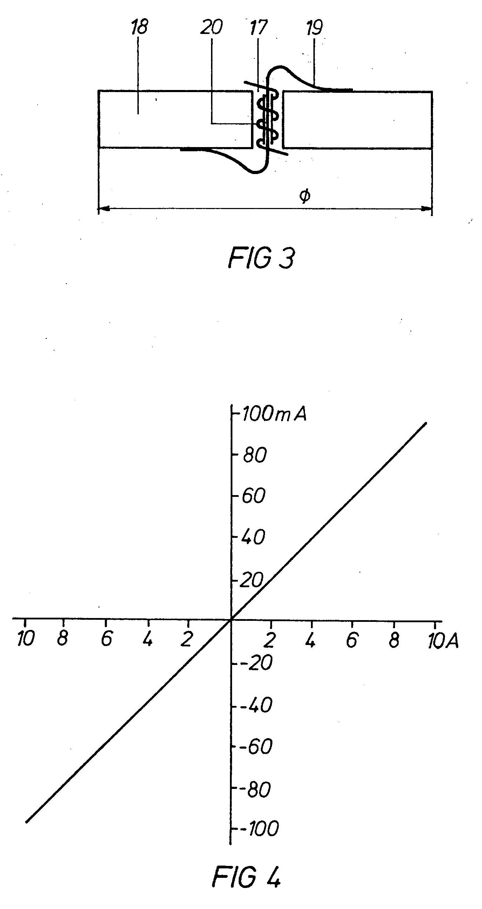

In Fig. 3 ist eine weitere Ausbildung des erfindungsgemaßen Stromsensors im Prinzip dargestellt. Eine Ansicht von oben zeigt, daß in einem Luftspalt 17 eines geschlitzten Kerns 18 ein Z-förmig gestaltetes streifenförmiges Element 19 aus amorphem Material angebracht ist, welches im mittleren Teil einen verstärkten Querschnitt aufweisen kann, wie durch zwei Striche angedeutet ist.

Mit 20 ist eine Indikatorwicklung bezeichnet, die auf den Mittelteil des verstärkten streifenförmigen Elementes gewickelt ist. Auf den Kern 18 ist - wie bei den vorigen Ausführungsbeispielen - die hier nicht gezeichnete Sekundärwicklung gewickelt. Bei kleinen Strömen ist der Stromsensor sehr empfindlich durch die feste Kopplung der Enden des streifenförmigen Elementes 19 mit dem Kern 18. Bei höheren Strömen werden die äußeren Teile des streifenförmigen Elementes 19 gesättigt, während der innere Teil infolge des größeren Querschnitts und der "Querlage" wegen noch nicht gesättigt ist, so daß die Richtungsinformation erhalten beibt.

Der Übersteuerungsbereich ist bei dieser Ausführung jedoch deutlich niedriger als bei den Ausführungsbeispielen nach Fig. 1 und 2, da in dem kleinen Luftspalt 17 des Kerns 18 hohe Feldstärken auftreten, die schließlich auch den mittleren Teil des bandförmigen Elementes 19 sättigen.

Fig. 4 zeigt die Kennlinie eines Stromsensors, der nach dem Prinzip gemäß Fig. 1 aufgebaut ist. Hierbei ist in der Abszissenachse der zu messende Strom in Ampere und in der Ordinatenachse der Strom an den Klemmen 15 in mA aufgetragen. Es wurde ein Kern 36 x 26 x 6 mm VACOPERM 100 verwendet; jedes streifenförmige Element bestand aus VITROVAC 6025 x 6 x 2,5 x 0,03 mm mit Indikatorwicklung 60 Windungen / 0,1 mm und Kompensationswicklung mit 100 Windungen. Das Schaubild läßt die gute Proportionalität zwischen Indikator und Meßstrom erkennen. Zur Nullpunkterkennung wurde die Schaltung nach Fig. 2 eingesetzt. Die Regelschaltung zur Erzeugung des Kompensationsstromes war in bekannter Technik aufgebaut.

## Patentansprüche

1. Stromsensor nach dem Kompensationsprinzip, insbesondere zur Messung von Gleich- und Wechselströmen, bei dem das in einem Magnetkern von einer vom zu messenden Strom durchflossenen Primärwicklung erzeugte Magnetfeld durch den Kompensationsstrom in einer Sekundärwicklung kompensiert wird, wobei zur Steuerung des Kompensationsstromes ein oder mehrere impulsförmig vormagnetisierte, mit je einer Indikatorwicklung (3, 3', 20) versehene streifenförmige Elemente (2, 2', 19) aus weichmagnetischem Material als Sensoren dienen, die Abweichungen vom Nullfluß erfassen und so angeordnet sind, daß sie von einem Teil des Magnetflusses des Magnetkerns durchsetzt werden, **dadurch gekennzeichnet**, daß das streifenförmige Element bzw. die streifenformigen Elemente (2, 2', 19) teilweise in oder in der Nähe des Bereiches eines Luftspaltes (16, 17) des Magnetkerns (1) und teilweise neben dem Magnetkern (1) an einer Stelle ohne Querschnittsverminderung angeordnet ist/sind.

2. Stromsensor nach Anspruch 1, **dadurch gekennzeichnet**, daß ein streifenförmiges Element (2') vorgesehen und derart ausgebildet und angeordnet ist, daß die Streifenenden soweit von der Querschnittsverminderung bzw. dem Luftspalt (16) entfernt sind, daß sie später in Sättigung gehen als der in der Nähe des Luftspaltes (16) oder der Querschnittsverminderung angeordnete Mittelteil.

3. Stromsensor nach den Ansprüchen 1 und 2, **dadurch gekennzeichnet**, daß zwei streifenförmige Elemente (2, 2') aus amorphem Material am inneren Umfang des Magnetkerns (1) symmetrisch angeordnet sind, wobei der Magnetkern (1) unter einem der beiden Elemente (2, 2') einen Luftspalt (16) aufweist.

4. Stromsensor nach Ansprunch 1, **dadurch gekennzeichnet**, daß in einem Luftspalt (17) des Magnetkerns (18) ein Z-förmiger Streifen (19) aus amorphem weichmagnetischem Material derart angeordnet ist, daß dessen Mittelteil sich im Luftspalt (17) befindet, während die beiden Enden des Streifens (19) an den einander gegenüberliegenden Seiten des Magnetkerns (1) anliegen.

5. Stromsensor nach Anspruch 4, **dadurch gekennzeichnet**, daß der Mittelteil des streifenförmigen Elementes (19) verstärkt ausgebildet ist.

## Claims

1. A current sensor operating in accordance with the compensation principle, in particular for the measurement of direct currents and alternating currents, wherein the magnetic field, generated in a magnetic core by a primary winding traversed by the current to be measured, is compensated by the compensation current in a secondary winding, wherein, for the control of the compensation current, one or more strip-like elements (2, 2', 19) composed of soft-magnetic material, magnetically biased in pulsed fashion and each provided with an indicator winding (3, 3', 20), serve as sensors, to detect deviation from the zero field, and are arranged in such manner that they are traversed by a part of the magnetic flux of the magnetic core, characterised in that the strip-like element or the strip-like elements (2, 2', 9) is/are arranged partially in or in the vicinity of the region of an air gap (16, 17) of the magnetic core (1) and partially beside the magnetic core (1) at a location with no cross-sectional reduction.

2. A current sensor as claimed in Claim 1, characterised in that a strip-like element (2') is provided and is designed and arranged in such manner that the strip ends are arranged at a distance from the cross-sectional reduction or the air gap (16) which is such that they become saturated at a later time than the central part arranged in the vicinity of the air gap (16) or the cross-sectional reduction.

3. A current sensor as claimed in Claim 1 and 2, characterised in that two strip-like elements (2, 2') composed of amorphous material are arranged symmetrically at the inner periphery of the magnetic core (1), where the magnetic core (1) comprises an air gap (16) below one of the two elements (2, 2').

4. A current sensor as claimed in Claim 1, characterised in that a Z-shaped strip (19) composed of amorphous, soft-magnetic material is arranged in an air gap (17) of the magnetic core (18) in such manner that the central part of said strip (19) is located in the air gap (17) whereas the two ends of the strip (19) abut against the sides, which are disposed opposite one another, of the magnetic core (1).

5. A current sensor as claimed in Claim 4, characterised in that the central part of the strip-like element (19) is of strengthened construction.

## Revendications

1. Capteur de courant selon le principe de la compensation, notamment pour la mesure de courants continu et alternatif, dans lequel le champ magnétique produit dans ce tore magnétique par un enroulement primaire parcouru par le courant à mesurer, est compensé par le courant de compensation dans un enroulement secondaire, tandis que pour commander le courant de compensation, un ou plusieurs éléments en forme de bandes (2, 2', 19) en un matériau magnétique mou, prémagnétisés sous forme d'impulsion et munis chacun d'un enroulement indicateur (3, 3', 20), servent de capteurs, qui captent les écarts à partir du flux zéro et sont disposés de façon à être traversés par une partie du flux magnétique du tore magnétique, capteur de courant caractérisé en ce que l'élément en forme de bande ou bien les éléments en forme de bandes (2, 2', 19) est disposé ou sont disposés partiellement dans ou au voisinage de la zone d'un entrefer (16, 17) du tore magnétique (1) et partiellement à côté du tore magnétique (1) à un emplacement sans réduction de la section transversale.

2. Capteur de courant selon la revendication 1, caractérisé en ce qu'un élément en forme de bande (2') est prévu et il est réalisé et disposé de façon que les extrémités de bandes soient éloignées de la réduction de section transversale ou bien de l'entrefer (16) dans une mesure telle qu'elles viennent à saturation plus tard que la partie médiane disposée au voisinage de l'entrefer (16) ou bien de la réduction de section transversale.

3. Capteur de courant selon les revendications 1 et 2, caractérisé en ce que deux éléments en forme de bandes (2, 2') en matériau amorphe, sont disposés symétriquement contre la périphérie interne du tore magnétique (1), tandis que ce tore magnétique (1) comporte sous un des deux éléments (2, 2') un entrefer (16) .

4. Capteur de courant selon la revendication 1, caractérisé en ce que, dans un entrefer (17) du tore magnétique (18) une bande en forme de Z (19) en un matériau magnétique doux amorphe est disposée de façon que sa partie médiane se trouve dans l'entrefer (17), tandis que les deux extrémités de la bande (19) s'appliquent sur les côtés opposés l'un à l'autre du tore magnétique (1).

5. Capteur de courant selon la revendication 4, caractérisé en ce que la partie médiane de l'élément en forme de bande (19) est renforcé.
